# EUROPEAN PATENT APPLICATION

(11) **EP 0 580 412 A1**
(43) Date of publication of application: **26.01.1994**
(21) Application number: 93305706.9
(22) Date of filing: 20.07.1993
(51) Int. Cl.: H05K 7/20

(54) **Cooling of electronic components**

(30) Priority: 21.07.1992 GB 9215442
(71) Applicant: BRITISH AEROSPACE PUBLIC LIMITED COMPANY, Farnborough, Hants. GU14 6YU (GB)
(72) Inventor: Smith, Stephen J.R., British Aerospace Defence Ltd, Preston, Lancashire PR4 1AX (GB)
(74) Representative: Eastmond, John

(57) **Abstract**

A rack (12) for supporting and cooling modules (32) containing electronic components is described. The rack has a plurality of slots formed therein for receiving said modules. The slots (10) are defined by interior surfaces of wall portions (14) to which each module is thermally coupled when same is positioned in the slot. Cooling fluid is distributed around the exterior surfaces of the wall portions forming the slots. Thus, heat is drawn away from the electronic components due to the thermal coupling between the module and the slot walls. Advantageously, the wall portion substantially enclose each module to provided maximum cooling capability. Furthermore, the walls of the module and/or the walls of the slot may be flexible, thereby allowing flexure thereof to enable physical contact between the module and the slot walls when the module is fitted in the slot, and no contact when it is desired to insert or remove the module from the slot. Compressible, thermally conducting shims for positioning between the modules and the slot walls are also disclosed.

## Description

This invention relates to racks for supporting and cooling modules containing electronic components, and to the modules supported in the racks.

It is common practice in many applications of electronics, such as avionics, to use racks (or backplanes) to facilitate the connection together of various separate modules containing electronics. A series of spaced-apart connectors are positioned on the rack for connection to correspondingly configured connectors on each of said modules. This allows various numbers and types of modules to be connected and disconnected as required for a particular overall system function.

As is well known to those skilled in the art, all electronic components, to a varying degree, produce heat when they are in operation. In some applications the surrounding air can provide sufficient cooling (for example as with electronic calculators), or alternatively a fan may be provided to dissipate the warm air from around the components and draw in fresh, cooler air to provide the desired cooling effect (for example as with many personal computers).

The problems of heat dissipation are compounded by enclosing the components, for example when positioned on a printed circuit board, in a casing - as is common practice in the field of removable electronic modules - to reduce the likelihood of damage to the electronic components contained therein, and to make them easier to transport and store.

Several prior proposals have been made which, with varying degrees of success and extravagance, enable cooling of modules when connected to racks. One such proposal uses a rack which comprises respective upper and lower hollow surfaces through which cooling fluid is fed. Each of the surfaces has a series of recesses defined therein which accommodate the uppermost portion of a cuboid electronics module, in the case of the upper surface, and the lowermost portion of the module, in the case of the lower surface. Because of the shape and orientation of the modules and the shallowness of the recesses, the proportion of the surface area of the module which is in direct contact with the upper and lower surfaces is relatively small, thus providing poor heat dissipation. Another proposal is to provide the modules with channels through which cooling fluid may pass. With this arrangement each module includes a fluid inlet and outlet which line up with a fluid outlet and inlet respectively, formed in appropriate positions in the recesses of a rack of the type described in the above-mentioned proposal, thereby allowing cooling fluid to pass through the modules. Although the latter proposal provides good heat dissipation, it is expensive and complicated to put into practice because each module requires its own fluid channels and, additionally, a control system must be provided for coolant distribution to prevent coolant being supplied to an outlet in a recess of the rack in which a module is not positioned at that time.

It is an object of the present invention to provide a more effective means for cooling modules when inserted in racks and the like.

According to one aspect of the invention there is provided a rack for supporting and cooling a module containing electronic components, the rack having a slot therein for receiving said module, the slot being defined by interior surfaces of wall portions to which the module is thermally coupled when same is positioned in said slot, and wherein cooling fluid is distributed around the exterior surfaces of said wall portions.

Preferably said wall portions substantially enclose said module. This may allow greater heat dissipation from the modules.

Advantageously, said wall portions are flexible, thereby allowing movement thereof relative to said module when positioned in said slot. This may allow the wall portions to come into contact with the module to provide improved heat dissipation, but also allows the modules to be easily removed.

The wall portions may move in response to cooling fluid pressure acting thereon. Also, the wall portions may be resiliently deformable such that they press against said module when same is positioned in said slot.

Optionally, the rack may further include compressible, thermally conducting shims for insertion between said wall portions and said module. These shims may be inserted in the rack at the same time as the module, or subsequently, and allow the dissipation of heat by bridging the gap between the module and the slot.

According to another aspect of the invention there is provided a module for insertion in a rack as described above, the module comprising external wall portions which are resiliently deformable such that they press against the slot wall portions when said module is positioned in said slot.

For a better understanding of the invention an embodiment of it will now be described with reference to and as illustrated in the accompanying drawings, in which:-
Figure 1 shows a perspective view of a rack having a plurality of slots into one of which a module is to be inserted;
Figures 2, 3 and 4 each show an end-on view of one slot of the rack in which a module is positioned.

To improve understanding of the invention, like elements which appear in more than one figure will be designated by the same reference numeral.

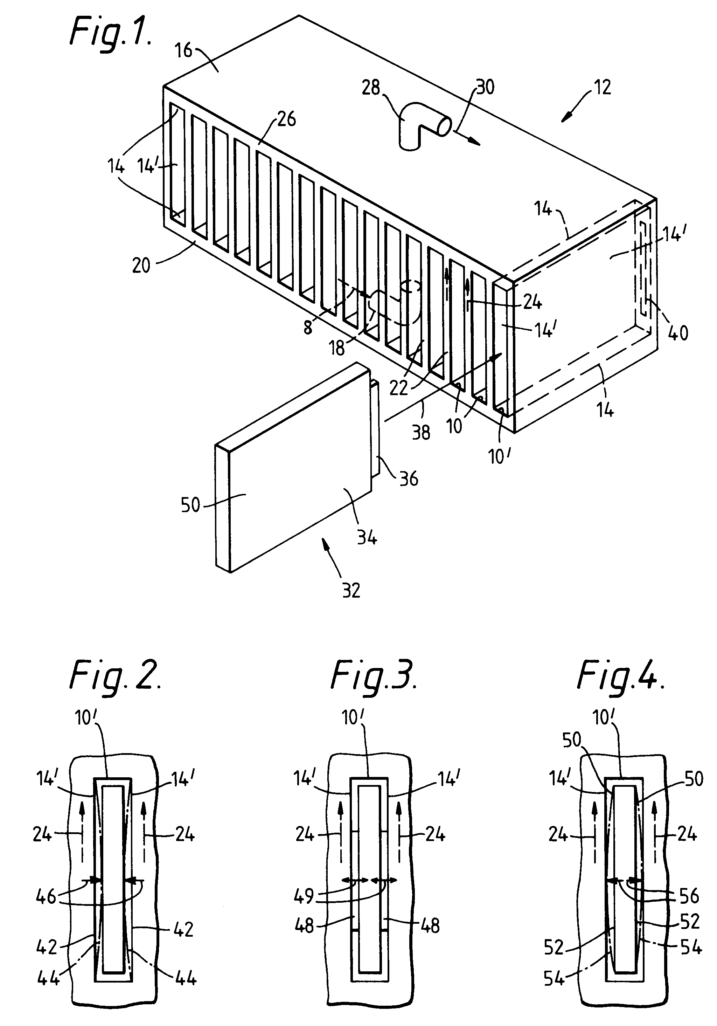

Referring initially to Figure 1, a rack having a plurality of slots 10 formed therein is shown generally at 12. Each slot 10 in the rack 12 is defined by the interior surfaces of respective wall portions 14 - made from materials of high thermal conductivity. The space defined between the outer surfaces of the casing 16 of the rack 12 and the exterior surfaces of the wall portions 14 of each of the slots 10 is occupied by cooling fluid (not shown). The cooling fluid is supplied from a reservoir or some other source (not shown) to inlet nozzle 18, as indicated by arrow 20. The fluid passes from the nozzle 18 into the lower portion 20 of the rack 12, then flows up the regions 22 between the slots 10 (as indicated by broken arrows 24), and finally to the top surface 26 of the rack 12 and then out of outlet nozzle 28 - as indicated by arrow 30. The output coolant may be cooled and recirculated in the rack 12 as desired.

Still referring to Figure 1, a module 32, sized for fitting into the slots 10, contains electronic components arranged on a printed circuit board or boards (not shown) capable of producing a specific required function. The electronic components are enclosed in a protective casing 34 having a connector 36 located at one end thereof. The casing 34 is made from materials of high thermal conductivity. When the function provided by the module 32 is required by a main processor system, the module 32 is inserted in the rack 12, for example in slot 10' - as illustrated by arrow 38. When the module 32 is fully positioned in the slow 10', the connector 36 on the module mates with correspondingly proportioned connector 40 located at the rearmost part of the slot 10'. The connectors 36 and 40 allow the transmission of data electrically, optically, or in other way between the module 32 and a main processor (not shown) connected to connector 40. For example, this processor could be the integrated flight control and propulsion control system (IFPCS) of an aircraft.

When the module 32 is connected to the main processor, the electronic components contained in the module are activated and begin to generate heat. This heat, combined with the heat given off by the components in any number of other similar modules contained in the other slots in the rack 12, can be quite significant and may cause malfunction of the components. To avoid this, cooling fluid (which is cooler than the modules 32 when in operation) is pumped into the rack 12 via inlet nozzle 18.

To ensure that there is good thermal contact between the case of the module 32 and the interior surface of the slot 10', while still allowing the module 32 to be easily slid in and out of the slot, the vertical wall portions 14' of the slot are designed to be flexible.

Figure 2 shows the range of flexure of the vertical walls 14', from position 42 (indicated by the solid lines) where the walls are substantially straight and do not contact the module 32, thereby allowing easy insertion and removal, and position 44 (indicated by the broken lines) where the walls come into contact with the module 32 once it has been fully inserted in the slot and the respective connectors 36 and 40 connected together. The movement of the vertical wall is indicated by arrows 46. By providing two positions for the walls, the easy insertion and removal of the module 32 is facilitated while allowing a substantial area of contact between the module casing 34 and walls 14' when the walls are in position 44, thereby providing good thermal conductivity from the module 32 to the slot 10'. The good thermal conductivity allows conduction of the heat from the module casing 34, which is heated by the operation of the electronic components contained therein, to be passed via the vertical walls 14' to the cooling fluid contained in the casing 16 of the rack 12. Thus, the cooling fluid increases in temperature, and is subsequently expelled via outlet nozzle 28; the module casing 34, and hence the components therein, are thus reduced in temperature.

The flexure of the vertical walls 14' of the slots 10 may be provided in many ways. For example, if the walls are sufficiently flexible, by applying the cooling fluid at a sufficiently high pressure, the walls could be made to take up position 44 in response to that fluid pressure.

Figure 3 shows another method of providing the desired good thermal conductivity between module and cooling fluid. With this method compressible shims are positioned between the vertical walls 14' of the slots 10 and the modules 32. The shims 48 may be inserted at the same time as the modules 32, or may be inserted subsequently. When positioned between the module and the slot walls, the shims 48 are held in compression (as indicated by arrows 49), thereby providing thermal contact between the module casing 34 and cooling fluid (via wall portions 14'). If the shims are manufactured from a material which is a good thermal conductor, this will allow the components in the module 32 to be sufficiently cooled. The compressibility of the shims 48 could be facilitated, for example, by forming the shims from corrugated pieces of metal.

Figure 4 shows yet another alternative for providing the good thermal conductivity between the module casing 34 and the slot walls. In this method the vertical walls 50 of the module casing 34 as manufactured from flexible materials. Advantageously, the walls are in position 52, i.e. straight (as indicated by the solid line), when the module 32 is inserted into the slot, and the walls are in position 54, i.e. pushed outwards in position 54 (as indicated by the broken line) after the module 32 has been fully inserted in the slot 10' and the respective connectors 36 and 40 have been connected together. The movement of the module vertical walls 50 could be facilitated, for example, by a helical spring acting against the walls, or by an other means which provides the desired movement. The direction of movement of the vertical walls 50 of the module 32 is indicated by arrows 56.

It should be appreciated that any combination of the methods of providing good conductivity described with reference to Figures 2, 3 and 4 could be used, in addition to their use individually.

## Claims

1. A rack for supporting and cooling a module containing electronic components, the rack having a slot formed therein for receiving said module, the slot being defined by interior surfaces of wall portions to which the module is thermally coupled when same is positioned in said slot, and wherein cooling fluid is distributed around the exterior surfaces of said wall portions.

2. A rack as claimed in claim 1, wherein said wall portions substantially enclose said module.

3. A rack as claimed in claim 1 or claim 2, wherein said wall portions are flexible, thereby allowing movement thereof relative to said module when positioned in said slot.

4. A rack as claimed in claim 3, wherein said wall portions move in response to cooling fluid pressure acting thereon.

5. A rack as claimed in claim 3, wherein said wall portions are resiliently deformable such that they press against said module when same is positioned in said slot.

6. A rack as claimed in any proceeding claim, further including compressible, thermally conducting shims for insertion between said wall portions and said module.

7. A module for insertion in a rack as claimed in any proceeding claim, the module comprising external wall portions which are resiliently deformable such that they press against the slot wall portions when said module is positioned in said slot.

8. A rack substantially as hereinbefore described with reference to and as illustrated in the accompanying drawings.

9. A module substantially as hereinbefore described with reference to and as illustrated in the accompanying drawings.
